# EUROPEAN PATENT SPECIFICATION

(11) **EP 3 503 401 B1**
(45) Date of publication and mention of the grant of the patent: **05.08.2020**
(21) Application number: 18212829.8
(22) Date of filing: 17.12.2018
(51) Int. Cl.: H03K 17/96

(54) **CONTROL DEVICE OF A HOUSEHOLD APPARATUS**
STEUERUNGSVORRICHTUNG EINER HAUSHALTSVORRICHTUNG
DISPOSITIF DE COMMANDE D'UN APPAREIL MÉNAGER

(30) Priority: 20.12.2017 SI 201700338
(43) Date of publication of application: 26.06.2019
(73) Proprietor: GORENJE gospodinjski aparati, d.d., 3503 Velenje (SI)
(72) Inventor: URSIC , Zoran, 5282 Cerkno (SI); NOVAK, Zlatko, 3320 Velenje (SI); MACKOVSEK, Roman, 3320 Velenje (SI)
(74) Representative: Ivancic, Bojan

(56) References cited:
- CN-B- 101 741 371
- DE-U1-202014 101 253
- US-A1- 2011 221 509

## Description

The present invention refers to a control device of a household apparatus, particularly to a capacitive switch for an electronic control device of the household apparatus.

In general, household apparatuses comprise an electronic control device with mechanical switches, microswitches, and touch switches with capacitive switches belonging thereto. Said capacitive switches operate by means of capacitive sensors which trigger a switch when capacitance that can be caused by a human body, for example, changes. Said electronic control device comprises an interface by means of which a user communicates with an apparatus. The interface can be comprised of a display that gives the user required information about the possibilities of the apparatus operation, and a control unit having a capacitive sensor by means of which the user controls the apparatus. Thus, within an entity of the electronic control device several elements are provided that need to be assembled fast and reliably.

A control device of the aforementioned kind is disclosed in documents CN 101 741 371 B and US 2011/221509 A1. Although the known solutions teach how to allow to control the equipment through the selection of specific functions and characteristics, without the need of gears with mobile pieces to detect the touch or its derivatives for such purpose, a major problem remain unsolved. During assembly of the control device, a conductive element in the form of a metal plate can jam at one side of an opening between the front plate and, respectively, the walls of said opening and the covering element resulting in a negative influence and the appearance of said unit of the electronic control device.

It is the object of the present invention to create such an electronic control device of a household apparatus that can be quickly and reliably assembled, and by means of which are eliminated drawbacks of the known electronic control devices.

According to the present invention, the object as set above is solved by features set forth in the characterising part of claim 1. Detail of the invention is disclosed in respective subclaims.

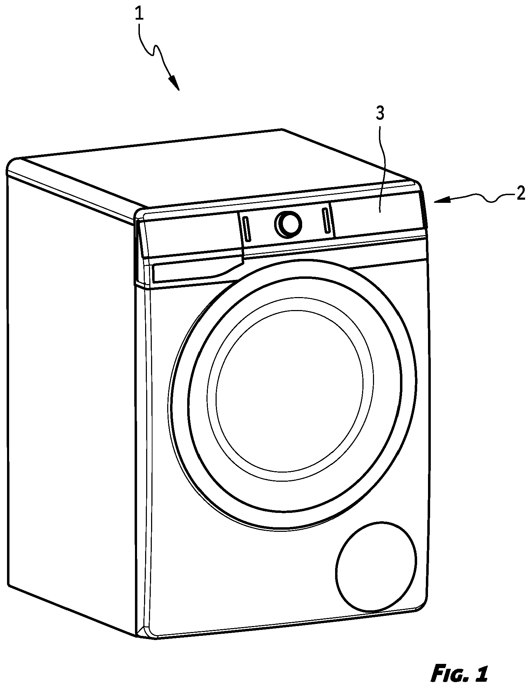

The invention is further described in detail by way of non-limiting embodiment, and with a reference to the accompanying drawings, where
Fig. 1 shows a three-dimensional view of a household apparatus with an electronic control device,
Fig. 2 shows a cross-sectional view of a capacitive switch of the electronic control device,
Fig. 3 shows another embodiment of the capacitive switch of Fig. 2.

A household apparatus 1 comprises a control front plate and, respectively, a control plate 2 with a display 3 forming together a control unit with at least one capacitive switch. The side of the front plate 2 facing the outside of the household apparatus 1, that is the outer side that usually is turned towards a user and is thus visible to the latter, is covered by means of a covering element 4 electrically non-conductive material such as film, glass or similar, for example. A printed circuit board 5 is attached at a distance from the front plate 2 of the household apparatus 1, said board 5 receiving data information from the user, process said information and/or send it to a respective unit which carries out each operation of the household apparatus 1. Said front plate 2 is formed in the area of each capacitance switch with a through hole 6, which is formed at least over a part of its rim, preferably over its entire rim, with a wall 7 projecting in direction towards said printed circuit board 5. It is provided for according to the present invention that the area of the connection of the wall 7 with the rim of the through hole 6 at the back side of the front plate 2 is formed with an enlargement 8 extending in radial direction of the through hole 6 and, respectively, in longitudinal direction of the front plate 2.

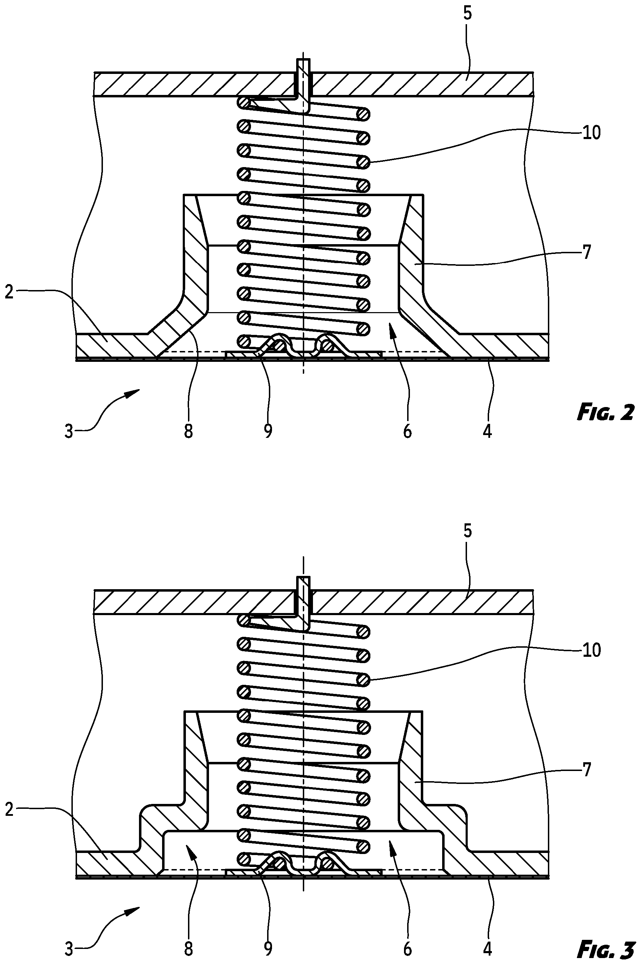

Said enlargement 8 can be shaped in a sense of a chamfer (cf. Fig. 2) formed over the entire rim of the through hole 6 and facing the covering element 4. Moreover, said enlargement 8 can resemble a stepwise form (cf. Fig. 3) formed over the entire rim of the through hole 6 and facing the covering element 4. Yet further, said enlargement 8 can resemble a shape of a fillet or similar.

In the central region of said through hole 6, particularly preferably in the central region of said enlargement 8, there is provided a triggering means 9 tightly pressed against the covering element 4, said triggering means 9 is connected by means of a resilient means 10 with the printed circuit board 5. To this extent it is provided that both the triggering means 9 and the resilient means 10 are made of electrically conductive material, and said connection from the triggering means 9 to the board 5 is electrically conductive as well. In the present embodiment, said triggering means 9 is selected as a circular metal plate, and said resilient means 10 is selected as a metal spring.

In order to prevent the triggering means 9 to jam anyhow between the front plate 2 and, respectively, the wall 7 and the covering element 4, said wall 7 is configured according to the invention as a limiter of a motion of the resilient means 10 in transversal direction thereof and, respectively, in longitudinal direction of the front plate 2 to the position in which the triggering means 9 presses against the wall 7 of the through hole 6. To this extent, said resilient means 10 is formed with a smaller outer dimension than the dimension of said through hole 6. Furthermore, it is provided for according to the invention that the outer dimension of the triggering means 9 is greater than the outer dimension of the resilient means 10 yet smaller than the dimension of said enlargement 8. According to the preferred embodiment is provided that the outer dimension of the triggering means 9 is greater than the outer dimension of the resilient means 10 yet smaller than the dimension of the through hole 6.

Said triggering means 9 and said resilient means 10 are mutually rigid connected in a manner that are non-movable against each other, preferably by means of a form fit. To this extent is provided that the triggering means 10 comprises one projection or plurality of projections grasping the resilient means 10. Furthermore is provided that the triggering means 9 comprises one projection or plurality of projections grasped by the resilient means 10. Moreover, a combination of the aforesaid can be utilised.

## Claims

1. A control device of a household apparatus comprising a front plate with a display forming together an electronic control unit with at least one capacitive switch, wherein a side of the front plate facing a user is covered by means of a covering element of electrically non-conductive material, wherein said electronic control unit comprises a printed circuit board attached at a distance from the front plate, wherein said front plate (2) is formed in the region of each of the at least one capacitive switch with a through hole (6), said through hole (6) being encircled at least over a part of its rim with a wall (7) projecting in direction towards said printed circuit board (5), wherein the area where the wall (7) is joined with said rim of the through hole (6) is formed with an enlargement (8), said area being located on an outside of the front plate (2) , said enlargement (8) extending in a radial direction of the through hole (6) and, respectively, in a longitudinal direction of the front plate (2), wherein a triggering means (9) in form of a metal plate is provided in a central region of said through hole (6) being tightly pressed against the covering element (4), said triggering means (9) is connected by means of a resilient means (10) with said printed circuit board (5), wherein both the triggering means (9) and the resilient means (10) are made of electrically conductive material, and wherein said wall (7) is configured to limit movement of the resilient means (10) in a transversal direction thereof and in longitudinal direction of the front plate (2) to the position in which the triggering means (9) is pressed against the covering element (4) in the area of the through hole (6).

2. A control device according to claim 1, ***characterized in that*** said enlargement (8) has a shape of a chamfer, a step, a fillet or similar formed over the entire rim of the through hole (6) that faces the covering element (4).

3. A control device according to any of the preceding claims, ***characterized in that*** said triggering means (9) and said resilient means (10) are mutually rigidly connected, preferably by means of a form fit.

4. A control device according to any of the preceding claims, ***characterized in that*** the triggering means (10) comprises one projection or a plurality of projections grasping the resilient means (10), or being grasped by the resilient means (10).

5. A control device according to any of the preceding claims, ***characterized in that*** said resilient means (10) is formed with a smaller outer dimension than the dimension of the through hole (6), and that the outer dimension of the triggering means (9) is greater than the outer dimension of the resilient means (10) yet smaller than the dimension of said enlargement (8).

## Patentansprüche

1. Steuerungsvorrichtung einer Haushaltsvorrichtung, die eine Frontplatte mit einer Anzeige umfasst, die zusammen eine elektronische Steuereinheit mit zumindest einem kapazitativen Schalter ausbilden, wobei die Seite der Frontplatte, die zu einem Benutzer zeigt, mittels eines Abdeckelements aus elektrisch nicht leitendem Material abgedeckt ist, wobei die elektronische Steuereinheit eine Leiterplatte umfasst, die in einem Abstand von der Frontplatte angeordnet ist, wobei die Frontplatte (2) in dem Bereich von jedem des zumindest einen kapazitativen Schalters mit einem Durchgangsloch (6) ausgebildet ist, wobei das Durchgangsloch (6) zumindest über einen Teil seines Randes mit einer Wand (7) eingekreist ist, die in Richtung zu der Leiterplatte (5) vorsteht, wobei das Gebiet, in dem die Wand (7) mit dem Rand des Durchgangslochs (6) verbunden ist, mit einer Erweiterung (8) ausgebildet ist, wobei das Gebiet an einer Außenseite der Frontplatte (2) angeordnet ist, wobei sich die Erweiterung (8) in eine radiale Richtung des Durchgangslochs (6) und entsprechend in eine longitudinale Richtung der Frontplatte (2) erstreckt, wobei ein Auslösemittel (9), das dicht gegen das Abdeckelement (4) gedrückt ist, in Form einer Metallplatte in einer zentralen Region des Durchgangslochs (6) bereitgestellt ist, wobei das Auslösemittel (9) mittels eines elastischen Mittels (10) mit der Leiterplatte (5) verbunden ist, wobei sowohl das Auslösemittel (9) als auch das elastische Mittel (10) aus einem elektrisch leitfähigen Material hergestellt sind und wobei die Wand (7) darauf ausgelegt ist, die Bewegung des elastischen Mittels (10) in seiner transversalen Richtung und in longitudinaler Richtung von der Vorderpatte (2) zu der Position einzuschränken, in der das Auslöseelement (9) gegen das Abdeckelement (4) in dem Gebiet des Durchgangslochs (6) gedrückt ist.

2. Steuerungsvorrichtung gemäß Anspruch 1, **dadurch gekennzeichnet, dass** die Erweiterung (8) die Form einer Fase, einer Stufe, einer Leiste oder Ähnliches aufweist, welches über den gesamte Rand des Durchgangsloches (6) ausgebildet ist, der zu dem Abdeckelement (4) zeigt.

3. Steuerungsvorrichtung gemäß einem der vorhergehenden Ansprüche, **dadurch gekennzeichnet, dass** das Auslösemittel (9) und das elastische Mittel (10) starr miteinander verbunden sind, vorzugsweise mittels eines Formschlusses.

4. Steuerungsvorrichtung gemäß einem der vorhergehenden Ansprüche, **dadurch gekennzeichnet, dass** das Auslösemittel (10) einen Vorsprung oder eine Vielzahl an Vorsprüngen umfasst, die in das elastische Mittel (10) greifen oder von dem elastischen Mittel (10) ergriffen werden.

5. Steuerungsvorrichtung gemäß einem der vorhergehenden Ansprüche, **dadurch gekennzeichnet, dass** das elastische Mittel (10) mit einer kleineren Außenabmessung ausgebildet ist als die Abmessung des Durchgangsloches (6) und dass die Außenabmessung des Auslösemittels (9) größer ist als die Außenabmessung des elastischen Mittels (10) aber kleiner als die Abmessung der Erweiterung (8).

## Revendications

1. Dispositif de commande d'un appareil ménager comprenant une plaque avant avec un dispositif d'affichage formant conjointement une unité de commande électronique avec au moins un interrupteur capacitif, un côté de la plaque avant faisant face à un utilisateur étant recouvert au moyen d'un élément de recouvrement en matériau non-conducteur de l'électricité, ladite unité de commande électronique comprenant une carte de circuits imprimés fixée à une distance de la plaque avant, ladite plaque avant (2) comportant, dans la région de chacun de l'au moins un interrupteur capacitif, un trou traversant (6), ledit trou traversant (6) étant encerclé au moins sur une partie de son rebord avec une paroi (7) se projetant en direction de ladite carte de circuits imprimés (5), la zone où la paroi (7) est reliée audit rebord du trou traversant (6) comportant un élargissement (8), ladite zone étant située sur un extérieur de la plaque avant (2), ledit élargissement (8) s'étendant dans une direction radiale du trou traversant (6) et, respectivement, dans une direction longitudinale de la plaque avant (2), un moyen de déclenchement (9) sous la forme d'une plaque de métal étant disposé dans une région centrale dudit trou traversant (6) en étant fermement pressé contre l'élément de recouvrement(4), ledit moyen de déclenchement (9) étant relié à l'aide d'un moyen élastique (10) à ladite carte de circuits imprimés (5), le moyen de déclenchement (9) et le moyen élastique (10) étant tous deux faits de matériau électroconducteur, et ladite paroi (7) étant configurée pour limiter un mouvement du moyen élastique (10), dans une direction transversale de celui-ci et dans une direction longitudinale de la plaque avant (2), à la position dans laquelle le moyen de déclenchement (9) est pressé contre l'élément de recouvrement (4) dans la zone du trou traversant (6).

2. Dispositif de commande selon la revendication 1, **caractérisé par le fait que** ledit élargissement (8) a une forme de chanfrein, de marche, de congé ou similaire, formée sur la totalité du rebord du trou traversant (6) qui fait face à l'élément de recouvrement (4).

3. Dispositif de commande selon l'une quelconque des revendications précédentes, **caractérisé par le fait que** ledit moyen de déclenchement (9) et ledit moyen élastique (10) sont mutuellement reliés de manière rigide, de préférence à l'aide d'une complémentarité de forme.

4. Dispositif de commande selon l'une quelconque des revendications précédentes, **caractérisé par le fait que** le moyen de déclenchement (9) comprend une saillie ou une pluralité de saillies saisissant le moyen élastique (10), ou saisies par le moyen élastique (10).

5. Dispositif de commande selon l'une quelconque des revendications précédentes, **caractérisé par le fait que** ledit moyen élastique (10) est formé avec une dimension externe plus petite que la dimension du trou traversant (6), et que la dimension externe du moyen de déclenchement (9) est plus grande que la dimension externe du moyen élastique (10) mais plus petite que la dimension dudit élargissement (8).
